# DEMANDE DE BREVET EUROPEEN

(11) **EP 1 311 144 A2**
(43) Date de publication de la demande: **14.05.2003**
(21) Numéro de dépôt: 02292795.8
(22) Date de dépôt: 08.11.2002
(51) Int. Cl.: H05K 1/11, H05K 3/18

(54) **Support de circuit imprimé à connexions intégrées et procédé de fabrication d'un tel support**

(30) Priorité: 09.11.2001 FR 0114747
(71) Demandeur: Nexans, 75008 Paris (FR)
(72) Inventeur: Joly, Bertrand, 92310 Sevres (FR)
(74) Mandataire: Feray, Valérie

(57) **Abrégé**

La présente invention concerne un support de circuit imprimé comprenant un substrat (2) en matière isolante, au moins un chemin de transport (3) du courant électrique constitué d'une métallisation du substrat et au moins un agencement de connexion (4) contigu audit chemin de transport (3).

Selon l'invention, ledit agencement de connexion (4) comprend au moins une bande de matière plastique souple métallisée formant un tronçon de conducteur et connectée électriquement audit chemin de transport (3).

## Description

La présente invention se rapporte à un support de circuit imprimé à connexions intégrées et à un procédé de fabrication d'un tel support.

De façon classique, les connexions de câbles électriques sur des supports à circuit imprimé sont réalisées au moyen de connecteurs séparés montés sur le support.

Dans le document de brevet WO 00/42679, est décrit un support de circuit imprimé comprenant un substrat de matière isolante électrique, une pluralité de chemins de transport du courant électrique en matière conductrice électrique déposée sur le substrat et une pluralité de connecteurs également intégrés et électriquement connectés aux chemins. Selon l'exemple décrit, le substrat est en résine renforcée de fibres de verre et lesdits chemins en matière conductrice électrique peuvent être en cuivre et être formés sur le substrat de façon usuelle par gravure à partir de couches de cuivre complète. Les connecteurs comprennent une fente revêtue sur sa surface intérieure de matière dure et conductrice électrique telle que du nickel. L'épaisseur de chaque fente est choisie de façon à être inférieure au diamètre du câble conducteur à connecter. Ainsi, lorsque ce câble est poussé dans la fente, la surface intérieure de celle-ci coupe et déplace l'isolation du câble entraînant un dénudement du câble et le contact électrique de sa partie conductrice avec la surface intérieure de la fente.

Le brevet US 4 973 262 décrit un support de circuit imprimé comprenant un substrat en matière isolante, un chemin de transport du courant électrique en matière conductrice électrique sur le substrat et un agencement de connexion formé d'une partie intégrée audit substrat et contigu audit chemin de transport, où le substrat avec son agencement de connexion est en matière plastique métallisée.

Selon un mode de réalisation, l'agencement de connexion comprend une fente moulée sur un bord du support et dont la surface interne est métallisée. La fente peut comprendre un bord angulaire tranchant. La fente peut être dans le plan du support ou inclinée d'un angle de 90° par rapport au plan du support. L'agencement de connexion peut comprendre une rainure moulée sur un bord du support et dont la surface interne est métallisée.

Ces agencements de connecteurs permettent la connexion de câbles sur un support à circuit imprimé sans nécessité de connecteurs séparés montés sur le support. Cependant, ce type de connecteur ne peut être réalisé que par usinage, en particulier perçage, ou moulage dans le substrat en matière plastique. Ceci nécessite un travail d'usinage ou de moulage sur le support relativement lourd.

L'invention propose de résoudre ce problème et, pour ce faire, elle propose un support de circuit imprimé comprenant un substrat en matière isolante, au moins un chemin de transport du courant électrique constitué d'une métallisation du substrat et au moins un agencement de connexion contigu audit chemin de transport, caractérisé en ce que ledit agencement de connexion comprend au moins une bande de matière plastique souple métallisée formant un tronçon de conducteur et connectée électriquement audit chemin de transport.

Selon un premier mode de réalisation, ladite bande est moulée d'une seule pièce avec le substrat.

Selon un second mode de réalisation, le support comporte un film souple fixé sur la pièce substrat et portant ledit chemin de transport et le tronçon de conducteur dudit agencement de connexion.

Avantageusement, le film est constitué d'une matière plastique.

De préférence, le film est constitué d'un polymère, de préférence du polyéthylène ou du polyimide.

Par ailleurs, des procédés de métallisation ont été développés ces dernières années permettant la métallisation de substrats en matière plastique dont un avantage réside dans leur mise en oeuvre très facile par moulage ou calandrage.

Un tel procédé est décrit dans le document de brevet EP 0 693 138.

Ce procédé de type connu est un procédé de métallisation de type positif d'une pièce substrat de matériau plastique composite contenant un copolymère et des grains d'un ou plusieurs oxydes métalliques, comprenant trois étapes successives dont la première consiste en une irradiation de la surface à métalliser de la pièce substrat par un faisceau de lumière émis par un laser excimère, la seconde consiste en l'immersion de la pièce irradiée dans au moins un bain autocatalytique contenant des ions métalliques et sans apport préalable de palladium, avec dépôt de ceux-ci en une couche sur la surface irradiée et la troisième étape consiste en un traitement thermique de la pièce métallique métallisée, de façon à obtenir une diffusion du métal déposé dans le matériau composite.

Un tel procédé permet la métallisation de matières plastiques diverses et en particulier de matières plastiques moulées.

La présente invention exploite la mise en oeuvre de tels procédés de métallisation pour la réalisation de supports à circuit imprimé et à connecteurs intégrés.

L'invention propose également un procédé de métallisation d'une pièce substrat particulièrement adapté à la fabrication d'un support tel que précisé ci-dessus et comprenant trois étapes successives qui sont :
- une étape de revêtement de la pièce par une couche de matériau composite précurseur, constitué d'une matrice polymère dopée de particules diélectriques en matériau photoréducteur,
- une étape consistant en une irradiation de la surface à métalliser de la pièce substrat par un faisceau de lumière émis par un laser,
- une étape consistant en une immersion de la pièce irradiée dans un bain autocatalytique contenant des ions métalliques, avec dépôt de ceux-ci en une couche sur la surface irradiée,
caractérisé en ce que la dimension desdites particules diélectriques est inférieure ou égale à 0,5 microns.

Le procédé décrit dans le document de brevet EP 0 693 138 nécessite l'incorporation dans la masse de la matière plastique formée d'un polymère d'une substance minérale dispersée dans la matière plastique et formée de grains d'oxyde, par exemple oxydes d'antimoine, d'aluminium, de fer, de zinc et d'étain, notamment en concentration volumique supérieure à 1% et de taille variable, mais de préférence de taille supérieure à 0,5 microns et n'excédant pas 50 microns. Ces oxydes sont de plus diffusés dans le matériau plastique par le traitement thermique final. En effet, l'adhérence résultante est accrue en faisant diffuser le métal vers l'intérieur du composite en utilisant le chauffage sélectif et de courte durée de la couche métallique procuré par un four à micro-ondes.

Cet apport de substances minérales dans le polymère modifie les propriétés propres du polymère, ce qui est préjudiciable, car la nature du polymère est optimisée pour l'application.

Pour résoudre ce problème, il peut être envisagé de prévoir, préalablement à la première étape, une étape de revêtement de la pièce par une couche de matériau composite précurseur constitué d'une matrice polymère dopée de particules diélectriques en matériau photoréducteur.

Un tel procédé est connu des brevets US 4 426 442 et US 4 853 252.

Selon ces brevets, la pièce est préalablement revêtue d'une couche de matériau photoréducteur. Cette couche est constituée d'une matrice polymère dopée de particules diélectriques, plus précisément de dioxyde de titane.

Selon les procédés décrits, il n'est pas considéré de dimension précise de ces particules et la couche peut atteindre 10 microns d'épaisseur.

Par dimension de particule, il est entendu le diamètre moyen de ces particules.

Or, il s'avère que lorsque ces particules sont de dimension relativement importante, les problèmes techniques suivants se présentent.

Tout d'abord, à fraction volumique constante des particules dans la matrice polymère, les forces d'adhésion des ions métalliques ultérieurement déposés sont moindres. Il est donc nécessaire d'utiliser des fractions volumiques importantes pour obtenir une bonne tenue de la métallisation, ce qui entraîne un coût de matériau important et limite les possibilités de choix du polymère, selon les compatibilités du polymère avec les particules.

De plus, afin d'obtenir un dépôt uniforme d'ions métalliques de métallisation, il est nécessaire de déposer une épaisseur relativement importante d'ions métalliques. Ceci est également particulièrement coûteux en matériau et de plus l'on obtient un dépôt relativement rugueux.

Enfin, la résolution latérale d'une zone ainsi métallisée est mauvaise. Par résolution latérale, il est entendu la régularité d'une bordure d'une telle zone.

Ceci est préjudiciable à l'obtention de zones précises métallisées, telles que des pistes de circuits intégrés, de bonne qualité et économiquement rentable.

Le procédé conforme à l'invention résout ces problèmes.

De plus, la préparation d'un tel matériau composite peut exploiter le développement rapide de la technologie des polymères dopés par des nanoparticules et en particulier la liaison chimique des nanoparticules avec une matrice polymère au moyen de ligands moléculaires.

La matrice polymère est réalisée en matériau sélectionné pour obtenir une bonne adhérence à son interface avec la pièce substrat. Son choix dépend donc de la matière de la pièce substrat. De préférence, des matériaux du type polyéthylène, polypropylène ou polyimide sont utilisés.

Avantageusement, lesdites particules diélectriques sont en matériau photoréducteur, et de préférence, lesdites particules diélectriques sont des oxydes choisis parmi ZnO, TiO₂, ZrO₂, Al₂O₃ ou CeO₂.

Avantageusement, ladite couche de matériau composite a une épaisseur d'au plus un micron, cette épaisseur pouvant être inférieure dans le cas où la taille des particules d'oxydes est nanométrique.

Ladite couche de matériau composite peut être appliquée selon des techniques classiques, telles que dépôt à la tournette, par dispersion, par revêtement par immersion, par sérigraphie, par projection ou par extrusion dans le cas d'une pièce substrat en forme de câble.

Selon un mode de réalisation préféré, dans le cas d'une pièce substrat en matériau plastique polymère, ladite couche de matériau composite est appliquée sur la pièce substrat par plaquage laser, lesdites particules diélectriques étant déposées sur la surface de la pièce substrat en matière plastique polymère préalablement au chauffage par laser selon une technique de dispersion ou étant injectées au moyen d'une buse durant le chauffage par laser.

Ceci est un exemple de réalisation. Il est entendu que, même dans le cas d'une pièce substrat polymère, il peut être envisagé de revêtir cette pièce d'une couche de matériau composite au lieu d'enrober, comme décrit plus haut, la poudre d'oxydes à la surface de la pièce substrat.

Après dépôt de la couche de matériau composite, selon la deuxième étape du procédé, cette couche est irradiée par un faisceau laser UV pulsé. Cette étape vise à activer la surface des petites particules diélectriques, mises à nu par l'ablation simultanée du polymère d'enrobage, pour le dépôt autocatalytique ultérieur de métal, par exemple de cuivre. Cette opération peut se faire de deux façons différentes : irradiation de toute la surface de la pièce ou irradiation au travers d'un masque de projection afin de n'activer que la surface à métalliser.

Si le dépôt du composite est fait par sérigraphie, les pistes futures sont déjà tracées. On peut alors irradier toute la surface de la pièce substrat, car seules les pistes seront activées pour le dépôt autocatalytique ultérieur.

L'utilisation de nanoparticules diélectriques présente plusieurs avantages. L'on obtient des surfaces très lisses avec une résolution latérale élevée. Il est également obtenu de grandes valeurs de recouvrement de surface de l'aire diélectrique activée, ce qui permet l'obtention d'une métallisation selon un film homogène et une adhérence de plus de 1 Kg/mm². Par exemple, dans le cas de particules de ZnO de diamètre 100 nm, le recouvrement de surface par la surface activée peut dépasser 50% pour une fraction volumique de nanoparticules n'excédant pas 10%.

L'emploi de masque de projection lors de l'irradiation laser permet d'éviter l'application d'une étape photolithographique afin de délimiter la zone de métallisation, en cas de métallisation partielle. A cet égard, le procédé est compatible avec des changements de niveaux entre deux surfaces du produit à métalliser.

La troisième étape du procédé comporte un dépôt autocatalytique de métal, de préférence de cuivre, par immersion de la pièce dans un bain autocatalytique, comme effectué dans l'art antérieur cité dans le préambule de la description. Dans le cas d'une métallisation partielle, à partir d'une surface entièrement couverte, une étape photolithographique est alors nécessaire, entre l'irradiation laser et l'immersion dans le bain autocatalytique, pour délimiter les surfaces à métalliser.

Après le dépôt autocatalytique, qui conduit à une épaisseur d'au plus quelques microns, on peut compléter le film par un dépôt électrolytique par des procédés connus. Ce dépôt est plus rapide et moins coûteux que le dépôt autocatalytique, indispensable uniquement dans une phase initiale permettant d'obtenir une bonne adhésion à la surface de l'oxyde et la réalisation d'un film continu. Egalement, on peut renforcer le dépôt autocatalytique par un autre procédé, par exemple par dépôt d'étain à la vague.

Ce nouveau procédé permet de séparer l'optimisation des propriétés de la pièce substrat de matériau plastique polymère d'une part et des constituants de la métallisation d'autre part. Le polymère utilisé pour la métallisation lors de la première étape peut différer de celui de la pièce substrat. Par exemple, il est possible de sélectionner pour la métallisation un matériau polymère qui a une absorption assez élevée à la longueur d'onde de 248 nm, qui est la longueur d'onde des lasers excimères du commerce les plus courants.

Un premier exemple de réalisation du procédé est décrit ci-après en détail.

Selon la première étape, une couche de matériau composite de polymère chargé d'oxyde de zinc ZnO est appliquée par plaquage laser sur une pièce substrat de matériau polymère, par exemple du polycarbonate. Ceci est réalisé par déplacement de la surface polymère à une vitesse constante d'environ 10 à 100 mm/s sous le faisceau laser continu, de préférence un laser CO₂. La puissance du laser est sélectionnée dans une fourchette de plusieurs dizaines à plusieurs centaines de Watts, de façon à chauffer la surface polymère et de permettre l'enrobage des particules de céramiques sous la surface du polymère rendue visqueuse. La poudre de céramique est déposée sur la surface polymère préalablement au chauffage par laser selon une technique de dispersion classique ou est injectée durant le chauffage par laser au moyen d'une buse. Par cette technique, les particules de ZnO d'une dimension de 0,5 microns sont noyées dans la surface traitée de polymère. L'épaisseur et la composition de la couche composite peuvent être réglées par variation des paramètres du laser, c'est-à-dire par sa puissance et sa vitesse de balayage.

Selon la seconde étape du procédé, la couche composite est activée par un laser excimère pulsé UV ( de longueur d'onde de 193 nm). Cette opération est réalisée avec les paramètres laser suivants : 50 à 200 impulsions à une fluence proche de 500 mJ /cm².

Un dépôt autocatalytique de cuivre est alors réalisé selon la troisième étape du procédé. La métallisation n'est réalisée que sur les zones traitées par laser. Une adhérence de 1,4 kg/mm² est ainsi obtenue au niveau de la métallisation au cuivre. Cette adhérence peut être mesurée par test de traction standard. Les tests de traction sont réalisés après fixation par collage de clous métalliques (diamètre de 2 mm) sur les pistes de cuivre à tester. Ces clous sont tirés perpendiculairement à l'échantillon sous une force croissante jusqu'à séparation, de façon à déterminer l'adhérence.

Un second exemple de réalisation du procédé est décrit ci-après en détail.

Selon la première étape, une couche de matériau composite de polymère chargé de particules d'oxyde zinc ZnO de diamètre moyen inférieur ou égal à 0,5 microns est appliquée sur une pièce substrat de matériau polymère par procédé à la tournette à une rotation de 500 à 2000 tours/mn.

La pièce substrat est un film de polycarbonate ou de silicium, d'une épaisseur de 500 microns.

La matrice polymère est du poly[bisphénol A carbonate-co-4,4'-(3,3,5-trimethylcyclohexylidene) diphenol carbonate] et le matériau composite est contenu dans un solvant, de préférence du 1,2 dichloroéthane.

Des agents dispersants usuels sont ajoutés à ce matériau précurseur.

Selon la seconde étape du procédé, la couche composite est activée par un laser excimère pulsé UV ( de longueur d'onde de 193 nm). Cette opération est réalisée avec les paramètres laser suivants : 1 à 5 impulsions à une fluence proche de 500 mJ /cm².

Un dépôt autocatalytique de cuivre est alors réalisé selon la troisième étape du procédé.

De plus, l'invention concerne une pièce métallisée grâce à la mise en oeuvre dudit procédé, comprenant une pièce substrat constituée d'un film souple.

Avantageusement, ledit film est constitué d'une matière plastique et en particulier d'un polymère, de préférence du polycarbonate.

Outre la résolution des problèmes techniques déjà précisés, l'invention permet la réalisation d'un film fin de matière plastique métallisé, dont l'épaisseur est particulièrement petite. Ce type de film peut trouver en autre son application dans la réalisation de métallisation de zones de substrat de forme complexe. En effet, dans de telles zones, il peut s'avérer très complexe ou même impossible de réaliser un traitement direct de métallisation conforme à l'invention. Par exemple, il peut s'avérer difficile de réaliser une irradiation laser dans des formes en creux où est souhaitée une métallisation par le procédé conforme à l'invention sur toute la surface du creux. Grâce à l'invention, dans de tels cas, ledit film métallisé est déposé, par exemple, par collage, sur ladite surface.

Il est à noter que l'on peut réaliser le dépôt des ions métalliques sur la surface irradiée du film rapporté soit avant soit après collage de ce dernier. Selon les courbures, on peut avoir avantage à le faire après. Ceci est possible, car la zone irradiée par le laser reste active longtemps après l'irradiation. Expérimentalement, il a été observé que cette activation durait plusieurs mois après irradiation.

Un troisième exemple de réalisation du procédé, relatif plus précisément à la fabrication d'un tel film métallisé, est décrit ci-après en détail.

Un film est extrudé en polyéthylène, polyimide ou Mylar par exemple de 50 microns d'épaisseur. Plus généralement, une épaisseur de 10 microns à 1 mm peut être envisagée. Ce film est passé en continu et en série dans un bac de déposition du matériau composite précurseur puis dans une étuve de séchage suivi d'un chauffage par exemple par irradiation laser CO2 puis de l'irradiation par un laser excimère d'activation. Un passage au bain autocatalytique peut se faire à vitesse lente ou en statique jusqu'à l'obtention d'une épaisseur de métal de 0,5 à 10 microns d'épaisseur.

Un tel film composite laminé peut donc être fabriqué en continu.

Une métallisation sélective pouvant prendre la forme de surfaces complexes et de haute définition avec une précision de l'ordre du micron peut également être réalisée pour la réalisation de protection radioélectrique de type écrans ou la circuiterie électronique dans des applications de type circuit imprimé, circuit intégré, carte magnétique, carte à puce ...

Les films élémentaires sont alors traités en séquence dans la phase d'irradiation par laser excimère à travers un masque de façon à imprimer sur le film la forme exacte et précise de la métallisation souhaitée qui apparaîtra lors du passage au bain autocatalytique .

Il est également à noter que des applications à la fabrication de membranes sélectives, de films à usage décoratif ou destinés à l'imprimerie sont également envisageables selon le procédé conforme à l'invention.

L'invention est également décrite ci-après plus en détail à l'aide de figures ne représentant que des modes de réalisation préférés de l'invention.

La figure 1 est une vue en perspective d'un support de circuit imprimé selon un premier mode de réalisation de l'invention.

La figure 2 est une vue en perspective d'un support de circuit imprimé selon un second mode de réalisation de l'invention.

La figure 3 est une vue en coupe partielle selon une première variante.

La figure 4 est une vue en coupe partielle selon une seconde variante.

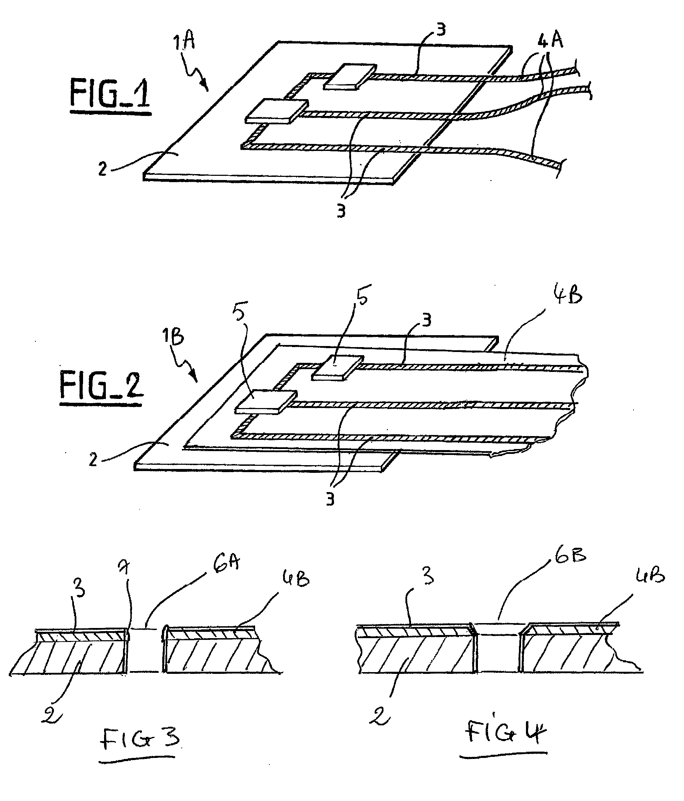

Comme représenté sur la figure 1, un support de circuit imprimé 1A comprend un substrat 2 en matière isolante et au moins un chemin de transport du courant électrique 3 en matière conductrice électrique sur le substrat 2 et au moins un agencement de connexion 4A formé d'une partie intégrée audit substrat 2 et contigu audit chemin de transport 3.

Selon l'invention, le substrat 2 avec son agencement de connexion 4 est en matière moulée et métallisée.

De préférence, cette matière est une matière plastique mais elle peut également selon l'invention être une matière céramique ou semiconductrice.

Dans le cas d'une matière plastique, cette dernière peut être du polycarbonate, du polybutadiène, du polyamide, du polypropylène, du polyéthylène, du polyéthylènestyrène, du PVC, de l'ABS, du polyimide, du polymère fluoré ou du polyoxyméthyle et la métallisation est de préférence réalisée grâce au procédé de métallisation décrit ci-dessus. Le métal utilisé est de préférence du cuivre, du nickel, du palladium, de l'aluminium ou du titane.

Selon le premier mode de réalisation représenté sur la figure 1, l'agencement de connexion 4A comprend des bandes de matière plastique souple métallisée formant chacune un tronçon de conducteur et connectées chacune électriquement à un chemin de transport 3.

De préférence, ces bandes 4A sont moulées d'une seule pièce avec le support 2 et sont métallisées lors de la métallisation des chemins de transport du courant électrique 3 sur le substrat 2.

Cet agencement permet un prolongement souple des chemins de transport 2 et une connexion de ceux-ci déplacée espacée du support.

Selon un second mode de réalisation représenté sur la figure 2, le support 1B comporte un film souple 4B en matière plastique fixé, avantageusement collé, sur la pièce substrat 2 et portant des chemins de transport 3 et les tronçons de conducteur de l'agencement de connexion.

Ce film est constitué d'un polymère, de préférence du polyéthylène ou du polyimide. La métallisation est de préférence réalisée grâce au procédé de métallisation décrit ci-dessus. Le métal utilisé est de préférence du cuivre, du nickel, du palladium, de l'aluminium ou du titane.

Dans sa partie de connexion non fixée sur le substrat 2, cette bande peut être découpée en bandes plus fines portant une métallisation afin de former des tronçons conducteurs du même type que ceux décrits sur la figure 1.

Selon une autre variante, cette partie de la bande est laissée telle quelle et forme un ruban de connexions conductrices parallèles.

La métallisation des chemins de transport 3 est réalisée soit avant collage du film 4B, soit après collage du film 4B sur le substrat 2.

Une fois ce film 4B collé sur le substrat 2, les composants 5 sont fixées par leurs pattes de connexion dans des orifices 6A, 6B agencés au travers du film 4B et du substrat 2 et de diamètre compris entre 35 et 150 microns.

Selon une variante représentée sur la figure 3, l'orifice 6A est percé au travers du film 4B et du substrat 2 sur la trajectoire d'un chemin de transport 3. La paroi de l'orifice est métallisée et un raccord 7 en étain appliqué à la vague est réalisé sur la tranche du film 4B.

Selon une autre variante représentée sur la figure 4, l'orifice 6B est percé au travers du film 4B et du substrat 2 sur la trajectoire d'un chemin de transport 3. Cet orifice 6B comporte une embouchure évasée qui est métallisée lors de la métallisation du chemin de transport 3. La paroi de l'orifice est métallisée et un raccord en étain appliqué à la vague est éventuellement réalisé au niveau d u raccord des deux métallisations.

Par rapport à la technique actuellement utilisée de connexion par connecteurs standards séparés, l'invention présente l'avantage de ne comprendre que les interfaces nécessaires aux connexions et entraîne donc une économie importante de moyens. En effet, ces connecteurs standards comportent classiquement de nombreux points de connexion, pouvant être au nombre de plusieurs dizaines, et donc, en utilisation, un nombre de points de connexion inutilisés non négligeable.

La description est relative à un substrat en matière plastique mais l'invention peut s'appliquer à d'autres matières telles que des polymères dopés ou non, des céramiques, des semi-conducteurs ou autres.

## Revendications

1. Support de circuit imprimé comprenant un substrat (2) en matière isolante, au moins un chemin de transport (3) du courant électrique constitué d'une métallisation du substrat et au moins un agencement de connexion (4) contigu audit chemin de transport (3), **caractérisé en ce que** ledit agencement de connexion (4) comprend au moins une bande de matière plastique souple métallisée formant un tronçon de conducteur et connectée électriquement audit chemin de transport (3).

2. Support selon la revendication 1, **caractérisé en ce que** ladite bande (4A) est moulée d'une seule pièce avec le substrat (2).

3. Support selon la revendication 1, **caractérisé en ce qu'**il comporte un film souple fixé sur la pièce substrat et portant ledit chemin de transport (3) et le tronçon de conducteur dudit agencement de connexion.

4. Support selon la revendication 3, **caractérisé en ce que** ledit film est constitué d'une matière plastique.

5. Support selon la revendication 4, **caractérisé en ce que** ledit film est constitué d'un polymère, de préférence du polyéthylène ou du polyimide.

6. Procédé de fabrication d'un support de circuit imprimé selon l'une des revendications précédentes par métallisation d'une pièce substrat, comprenant trois étapes successives qui sont une étape de revêtement de la pièce par une couche de matériau composite précurseur, constitué d'une matrice polymère dopée de particules diélectriques en matériau photoréducteur, une étape consistant en une irradiation de la surface à métalliser de la pièce substrat par un faisceau de lumière émis par un laser, une étape consistant en une immersion de la pièce irradiée dans un bain autocatalytique contenant des ions métalliques, avec dépôt de ceux-ci en une couche sur la surface irradiée, **caractérisé en ce que** la dimension desdites particules diélectriques est inférieure ou égale à 0,5 microns.

7. Procédé selon la revendication 6, **caractérisé en ce que** lesdites particules diélectriques sont des oxydes choisis parmi ZnO, TiO₂, ZrO₂, Al₂O₃ ou CeO₂.

8. Procédé selon l'une des revendications précédentes, **caractérisé en ce que** ladite couche de matériau composite a une épaisseur d'environ un micron.

9. Procédé selon l'une des revendications précédentes, **caractérisé en ce que** ladite étape ultérieure (B) est complétée par une étape de dépôt électrolytique.

10. Procédé selon l'une des revendications précédentes, **caractérisé en ce que** la pièce substrat est en matériau plastique polymère et ladite couche de matériau composite est appliquée sur la pièce substrat de matériau plastique polymère par plaquage laser.

11. Procédé selon la revendication 10, **caractérisé en ce que** lesdites particules diélectriques sont déposées sur la surface de la pièce substrat en matière plastique polymère préalablement au chauffage par laser selon une technique de dispersion.

12. Procédé selon la revendication 10, **caractérisé en ce que** lesdites particules diélectriques sont injectées au moyen d'une buse durant le chauffage par laser.
